# EUROPÄISCHE PATENTANMELDUNG

(11) **EP 1 137 059 A1**
(43) Veröffentlichungstag der Anmeldung: **26.09.2001**
(21) Anmeldenummer: 00106458.3
(22) Anmeldetag: 24.03.2000
(51) Int. Cl.: H01L 21/336

(54) **Halbleiterbauelement, Verfahren zu seiner Herstellung und Verfahren zur Herstellung von elektrischen Verbindungen zwischen einzelnen Schaltungselementen**

(71) Anmelder: Infineon Technologies AG, 81669 München (DE)
(72) Erfinder: Cappellani, Annalisa, 96100 Siracusa (IT); Lachner, Rudolf, Dr.rer.nat, 85051 Ingolstadt (DE)
(74) Vertreter: Lange, Thomas, Dr.

(57) **Zusammenfassung**

Die Erfindung betrifft ein Verfahren zur Herstellung eines auf einem Halbleiter-Substrat (1) ausgebildeten integrierten Bauelements mit mehreren gegenüber der Hauptoberfläche (11) des Substrats aufragend ausgebildeten Elektrodenanschlüssen (21, 22, 23, 26), wobei die Elektrodenanschlüsse (21, 22, 23, 26) gleichzeitig durch Entfernen der Elektrodenanschluss-Schicht (2) und/oder der Isolationsdeckschicht (3a) in an die Elektrodenanschlüsse (21, 22, 23, 26) angrenzenden Bereichen (3a1, 3a2) ausgebildet werden. Weiterhin betrifft die Erfindung ein Verfahren zur Herstellung von elektrischen Verbindungen (24, 25, 101 bis 106) zwischen einzelnen auf bzw. in einem Halbleiter-Substrat (1) ausgebildeten Schaltungselementen (21, 22, 23, 26, LDD1, LDD2, HDD1 bis HDD3), wobei Leiterbahnkanälen in die planarisierte Fläche (111, 112) aus Schaltungselementen (LDD1, LDD2, HDD1 bis HDD3, 21, 22, 23, 26) und Füllmaterial (70 bis 75) hinein gefertigt werden, und die Leiterbahnkanäle mit einem gut leitenden Material (10, 101 bis 106) aufgefüllt werden. Ferner betrifft die Erfindung ein Halbleiterbauelement mit mehreren aufragend ausgebildeten Elektrodenanschlüssen.

## Beschreibung

Die Erfindung bezieht sich auf ein Verfahren zur Herstellung eines auf einem Halbleiter-Substrat ausgebildeten integrierten Bauelements mit mehreren gegenüber der Hauptoberfläche des Substrats aufragend ausgebildeten Elektrodenanschlüssen, auf ein Verfahren zur Herstellung von elektrischen Verbindungen zwischen einzelnen auf beziehungsweise in einem Halbleiter-Substrat ausgebildeten Schaltungselementen und auf ein Halbleiterbauelement mit mehreren aufragend ausgebildeten Elektrodenanschlüssen.

Damit Transistoren, insbesondere Feldeffekttransistoren, auch in einem sehr hohen Frequenzbereich, namentlich einige Gigahertz, arbeiten können, müssen sie sehr niedrige parasitäre Kapazitäten und Impedanzen aufweisen, da diese die Leistungsfähigkeit und Brauchbarkeit des gesamten Transistors begrenzen. So begrenzen die parasitären Kapazitäten und Impedanzen insbesondere die Schaltgeschwindigkeit und die maximale Oszillationsfrequenz und Verschlechtern das Rauschverhalten. Kommt ein Transistor innerhalb einer integrierten elektronischen Schaltung auf bzw. in einem Halbleiter-Substrat zum Einsatz, so spielt auch das die einzelnen Komponenten der Schaltung verbindende Leitungssystem eine große Rolle bei der Schaltgeschwindigkeit der Schaltung und ein möglichst geringer Widerstand des Leitungssystems ist für eine hohe Leistungsausbeute und damit auch für eine Geschwindigkeitserhöhung notwendig.

Durch die bloße Reduzierung der Dimensionen der bisher bekannten Transistor-Strukturen, beispielsweise Reduktion der Gate-Länge eines Feldeffekttransistors auf etwa 100 Nanometer, wird der Widerstand durch lithografische und physikalische Effekte ("narrow line effects") drastisch erhöht, insbesondere sofern man herkömmliche Silizidierung von Gate-Elektroden zur Kontaktierung derselben heranzieht, da hier das wenige Material noch weiter reduziert wird. Bei einer Verkleinerung der herkömmlichen Strukturen, insbesondere der Gate-Längen und den damit zusammenhängenden weiteren Dimensionen geht auch die Notwendigkeit der Reduzierung der vertikalen Dimensionierung der Strukturen einher, um Kurzkanaleffekte ("short channel effects") in Grenzen zu halten. Die Kontaktierung derart flacher Elektrodenanschlüsse benötigt zudem einen enormen technischen Aufwand in der Strukturierung. Durch die Silizidation wird zudem ein beträchtlicher Teil der hoch dotierten Regionen der flachen Elektrodenanschlüsse verbraucht, wodurch die Funktionalität und die physikalischen Parameter negativ beeinflusst werden. Namentlich werden auch hier wieder die Kontaktwiderstände erheblich erhöht. Bewegt man sich in Dimensionierungsgrößen unterhalb eines Mikrons, so stellen die Kurzkanaleffekte als Brücken oder Durchschlagszonen und die Verringerung der Transistorelektronen ("hot electrons") die größten Hindernisse dar. Ein Mittel diesem zu begegnen, ist die Substratdotierung zu erhöhen, was wiederum in einer Erhöhung der Anschluss-Kapazität einen nachteiligen Effekt erzielt.

Die parasitären Kapazitäten werden durch die räumliche Nähe zwischen den einzelnen Elektroden erheblich erhöht.

Für die Erzielung derart kleiner Strukturen ist eine technisch sehr aufwendige und sehr teuere Lithografie notwendig, um die kleinen Strukturen realisieren zu können.

Aus der JP-A 07-324 749 ist ein Halbleiter-Bauelement und ein Verfahren zu seiner Herstellung bekannt geworden, bei dem eine Hilfsstruktur zur Anwendung kommt, die als Isolierungsschicht zur Reduktion der Anschluss-Kapazität dient. Allerdings ist bei dieser Vorgehensweise keine Reduktion der parasitären Kapazitäten zwischen den einzelnen Elektroden möglich und so ist folglich auch nicht aufgezeigt, wie dem Problem der hohen Widerstände der Elektrodenanschlüsse begegnet werden kann, Sorge getragen.

Vorbekannte Strukturen zeichnen sich dadurch aus, dass sie eine Vielzahl einzelner Herstellungsschritte benötigen, wobei eine zeit- und kostensparende gleichzeitige Herstellung aller Elektrodenanschlüsse und der elektrischen Verbindungen zwischen den einzelnen Schaltungselementen nicht ermöglicht wird.

Aus Widmann et al., "Technologie hochintegrierter Schaltungen", 2. Auflage, Springer Verlag ist ein Feldeffekttransistor vorbekannt, bei dem noch die übliche Technik des Feldoxids zur Isolierung verwendet wird, bei dem zur Herstellung der Leiter- und Kontaktschicht zusätzliche Masken und Verfahrensschritte notwendig sind.

Nach Alvares, "BiCMOS TECHNOLOGY AND APPLICATIONS", Kluwer Academic Publishers, ISBN 0-7923-9033-4 ist die Verwendung einer Titan-Nitridschicht zur lokalen Verdrahtung beschrieben. Jedoch sind auch hier zur Erstellung der lokalen Verdrahtung aufwendige Fotoentwicklungs- und Prozess-Schritte notwendig, wobei sich die relativ hochohmigen Schichten der Titan-Nitridschichten (15 Ohm/Square) nachteilig auswirken.

Somit sind der Anwendbarkeit der herkömmlichen Halbleitertechnik im SHF-Bereich, insbesondere im Bereich mehrerer Gigahertz, dadurch Grenzen gesetzt, dass durch die herkömmliche Technik der Herstellung von Elektrodenkontakten und elektrischen Verbindungen innerhalb der integrierten Schaltung durch die parasitären Kapazitäten und durch die technologiebedingten ohmschen Widerstände der Leitungen und Kontakte begrenzt.

Somit stellt sich das Hauptproblem in der Herstellung von Transistorstrukturen mit einem hinreichend geringen Kontaktwiderstand an den Source-, Drain- und Gate-Kontakten und einer entsprechend geringen parasitären Kapazität zwischen den Anschlüssen und dem Substrat dar.

Aufgabe der Erfindung ist es, ein integriertes Bauelement und ein Verfahren zu seiner Herstellung zur Verfügung zu stellen, das die oben genannten Nachteile vermeidet und unter Einsparung von Maskenschritten beim Herstellungsprozess insbesondere die Ausbeute bei der Produktion erhöht und die Produktionskosten hierdurch und durch die Zeitersparnis verringert. Weiterhin ist es Aufgabe der Erfindung ein Herstellungsverfahren für elektrische Verbindungen zwischen einzelnen auf beziehungsweise in einem Halbleiter-Substrat ausgebildeten Schaltungselementen zur Verfügung zu stellen, das die hierfür notwendigen Prozess-Schritte auf ein Minimum reduziert, wobei die Leitfähigkeit der elektrischen Verbindungen maximiert ist.

Die Lösung dieser Aufgabe erfolgt verfahrensmäßig mit den kennzeichnenden Merkmalen der Ansprüche 1 und 26 und vorrichtungsmäßig mit den kennzeichnenden Merkmalen des Anspruchs 31.

Erfindungsgemäß ist vorgesehen, dass ein auf einem Halbleiter-Substrat ausgebildetes integriertes Bauelement mit mehreren gegenüber der Hauptoberfläche des Substrats aufragend ausgebildeten Elektrodenanschlüssen vermittels der folgenden Verfahrensschritte hergestellt wird:
- Ausbilden einer das Substrat wenigstens teilweise bedekkenden Isolationsschicht auf der Hauptoberfläche des Halbleiter-Substrats,
- Ausbilden einer Isolationsdeckschicht auf der Isolationsschicht,
- Teilweises entfernen der Isolationsschicht mit der darüber liegenden Isolationsdeckschicht,
- Aufbringen einer Elektrodenanschluss-Schicht auf der Hauptoberfläche des Halbleiter-Substrats und/oder auf der Isolationsdeckschicht, und
- Gleichzeitiges Ausbilden der erhöhten, gegenüber der Hauptoberfläche aufragenden Elektrodenanschlüsse durch Entfernen der Elektrodenanschluss-Schicht, insbesondere durch einen Ätzvorgang, in an die zu schaffenden Elektrodenanschlüsse angrenzenden Bereichen und/oder durch Entfernen der Isolationsdeckschicht in an den zu schaffenden Elektrodenanschluss angrenzenden Bereichen.

Die Erfindung schlägt vor, alle Elektrodenanschlüsse des integrierten Halbleiterbauelements gleichzeitig auf der Hauptoberfläche des Substrats aus einer Elektrodenanschluss-Schicht herzustellen. Der Vorteil dieser Vorgehensweise liegt darin, dass durch die gleichzeitige Herstellung der Elektrodenanschlüsse die sogenannte selbstjustierende ("self aligned") Technik eröffnet ist, was insbesondere bei Dimensionen der Strukturen nahe der Auflösungsgrenze sehr von Vorteil ist. Durch die gleichzeitige Herstellung werden sonst bei nichtsimultaner Herstellung übliche Masken- und Ätz- beziehungsweise Strukturierungs-Schritte zusätzlich eingespart.

Vorteilhafterweise wird gleichzeitig mit den Elektrodenanschlüssen das Halbleiterbauelement mit weiteren auf beziehungsweise in dem Halbleiter-Substrat ausgebildeten, integrierten Bauelementen verbindende Leiterbahnen hergestellt. Hierdurch werden wie die Elektrodenanschlüsse die Leiterbahnen und elektrischen Verbindungen in ebenfalls in selbstjustierender Technik hergestellt bzw. werden nicht in extra durchzuführenden Schritten, die eigene Maskenschritte erfordern, hergestellt.

Gemäß einer vorteilhaften Ausgestaltung der Erfindung ist vorgesehen, dass die Leiterbahnen aus der Elektrodenanschluss-Schicht hergestellt werden, wobei die Elektrodenanschluss-Schicht in an die zu schaffenden Leiterbahnen angrenzenden Bereichen, insbesondere durch einen Ätzvorgang, entfernt wird.

Von Vorteil wird ein erster und/oder ein dritter Elektrodenanschluss direkt auf dem Substrat und/oder zum Teil auf der Isolationsdeckschicht ausgebildet.

Gemäß einer besonders vorteilhaften und daher bevorzugten Ausgestaltung der Erfindung ist vorgesehen, dass ein zweiter Elektrodenanschluss vollständig auf der Isolationsdeckschicht ausgebildet wird. Hierdurch ist ein vom Substrat elektrisch isoliert ausgebildeter Gate-Kontakt ermöglicht.

Von Vorteil wird nach der Herstellung der Elektrodenanschlüsse auf dem Halbleiter-Substrat bzw. auf der Isolationsdeckschicht wenigstens ein innerhalb des Halbleiter-Substrats liegender dotierter Bereich ausgebildet. Hierdurch wird beispielsweise eine Feldeffektzone möglich, was den Aufbau einer Diode oder eines Transistors ermöglicht. Ebenso gut ist auch eine Herstellung eines Substratanschlusses mit verbessertem Übergangskontakt ermöglicht.

Gemäß einer bevorzugten Ausgestaltung der Erfindung wird der dotierte Bereich durch eine Diffusion eines Dotierungs-Materials durch die Isolationsschicht und/oder aus dieser in das Halbleiter-Substrat hinein hergestellt. Hierdurch kann der dotierte Bereich besonders einfach und lokal begrenzt hergestellt werden.

Ein weiterer vorteilhafter Verfahrensschritt sieht vor, dass wenigstens ein erster und ein zweiter Elektrodenanschluss wenigstens teilweise auf der Isolationsschicht hergestellt werden, wobei in einem Zwischen-Bereich zwischen den beiden Elektrodenanschlüssen die Elektrodenanschluss-Schicht und die Isolationsdeckschicht über der Isolationsschicht entfernt werden.

Der dotierter Bereich wird von Vorteil in dem Zwischen-Bereich unter der Isolationsschicht hergestellt.

Vor dem Herstellen des dotierten Bereichs werden nach einem weiteren bevorzugten Verfahrensschritt Seitenisolierungsschichten an den Seitenflächen des wenigstens einen Elektrodenanschlusses dergestalt hergestellt, dass die Eindiffusion des Dotierungs-Materials in den wenigstens einen Elektrodenanschluss vermieden wird.

Bevorzugterweise werden wenigstens drei Elektrodenanschlüsse hergestellt, wobei zwischen jeweils zwei der drei Elektrodenanschlüsse je ein dotierter Bereich unter der Isolationsschicht im Halbleiter-Substrat hergestellt wird. Hierdurch ist eine Struktur zur Herstellung eines Feldeffekttransistors ermöglicht.

Ein weiterer vorteilhafter Verfahrensschritt sieht vor, in den Bereichen in denen die Elektrodenanschlüsse direkt auf dem Substrat ausgebildet sind Dotierstoffe von den Elektrodenanschlüssen in Eindiffusionsbereiche des Substrats zur besseren Kontaktierung der Elektrodenanschlüsse mit dem Substrat und/oder des dotierten Bereichs hinein diffundiert werden, insbesondere durch einen Temperierungsprozess ("annealing"). Hierdurch ist ein besserer elektrischer Kontakt der Elektrodenanschlüsse mit dem dotierten Bereich und/oder dem Substrat gewährleistet.

Eine bevorzugte und vorteilhafte Ausgestaltung sieht vor, dass die Elektrodenanschluss-Schicht und/oder wenigstens einer der Elektrodenanschlüsse und/oder wenigstens eine Leiterbahn teilweise oder ganz über wenigstens einer in dem Halbleiter-Substrat ausgebildeten flachen Grabenisolation ("shallow-trench isolation") ausgebildet wird. Hierdurch können parasitäre Kapazitäten weiter reduziert werden.

Von Vorteil wird durch das erfindungsgemäße Verfahren ein Feldeffekttransistor mit wenigstens einem Source- einem Gate- und einem Drain-Anschluss und/oder ein Substratanschluss hergestellt.

Eine bevorzugte Ausgestaltung sieht vor, dass auf dem Substrat und/oder der Isolationsschicht und zwischen den Elektrodenanschlüssen und/oder den Leiterbahnen eine Auffüllung dergestalt aufgebracht wird, dass eine planarisierte, ebene Oberfläche entsteht, die mit der dem Substrat abgewandten Seite der Elektrodenanschlüsse und/oder der Leiterbahnen abschließt. Dem folgend wird von Vorteil für die Auffüllungen Oxid und/oder Bor-Phosphor-Silikatglas verwendet.

Gemäß eines besonders vorteilhaften und daher bevorzugten Verfahrensschritts wird/werden wenigstens einer der Elektrodenanschlüsse und/oder der Leiterbahnen bis zu einer vorbestimmten Höhe - insbesondere in die vorher planarisierte Oberfläche hinein - abgetragen.

Die sich durch das Abtragen des/der Elektrodenanschlusses bzw. der Leiterbahn(en) zwischen den vormals diesen angrenzenden Auffüllungen gebildete Vertiefung wird von Vorteil mit einer Leiterschicht aus einem gut leitenden Material ausgefüllt. Dem folgend wird nach einer weiteren vorteilhaften Ausgestaltung der Erfindung als gut leitendes Material Titan und/oder Wolfram und/oder Aluminium und/oder Tantal und/oder Kupfer und/oder Gold und/oder Platin und/oder eine Kombination derselben verwendet.

Bevorzugterweise wird nach dem Auffüllen der Vertiefung mit dem gut leitenden Material durch eine Temperierung ("annealing") eine Silizidierung des gut leitenden Materials mit dem darunter liegendem Elektrodenanschluss oder der Leiterbahn bzw. der Elektrodenanschluss-Schicht hergestellt. Hierdurch wird die Kontaktierung des gut leitenden Materials mit dem darunter liegenden Elektrodenanschluss weiter verbessert.

Zur weiteren Verbesserung des Kontakts ist nach einer weiteren Ausgestaltung des Verfahrens vorgesehen, dass vor dem Auffüllen mit dem gut leitenden Material die die Vertiefung bildende von der Hauptoberfläche des Substrats abgewandte Seitenfläche des Elektrodenanschlusses oder der Leiterbahn und/oder die der Vertiefung zugewandten Seitenflächen der Auffüllung oder der Seitenflächenisolationsschichten mit einer Kontaktschicht bedeckt werden.

Eine besonders bevorzugte Ausgestaltung sieht vor, dass die Auffüllung mit dem gut leitenden Material eine Leiterschicht ("local interconnect system") bildet, mit der einzelne integrierte auf bzw. in dem Halbleiter-Substrat ausgebildete Bauelemente miteinander verbunden werden. Hierdurch kann in einem Masken-/Herstellungsschritt mit den Elektrodenanschlüssen die Verbindungs-/Leitungsschicht zur elektrischen Verbindung der einzelnen elektronischen Bauelemente einer integrierten Halbleiterschaltung auf einem gemeinsamen Substrat in sog. "self-alinging"-Technik (selbstjustierend) hergestellt werden. Hierzu sonst notwendige Masken- und Strukturierungs-schritte entfallen.

Ein weiterer Aspekt der Erfindung betrifft ein Verfahren zur Herstellung von elektrischen Verbindungen zwischen einzelnen auf bzw. in einem Halbleiter-Substrat ausgebildeten Schaltungselementen, mit den Verfahrensschritten:
- Herstellen der einzelnen, zu verbindenden Schaltungselementen in bzw. auf dem Halbleitersubstrat,
- Planarisieren der Schaltungselemente auf bzw. in dem Halbelitersubstrat (1) durch Auffüllen von Vertiefungen und Unebenheiten mit einem Füllmaterial,
- Fertigen von Leiterbahnkanälen in die planarisierte Fläche aus Schaltungselementen und Füllmaterial hinein, und
- Auffüllen der Leiterbahnkanäle mit einem gut leitenden Material.

Nach dem Auffüllen der Leiterbahnkanäle mit dem gut leitenden Material wird das unter den Leiterbahnkanälen liegende Halbleitermaterial mit dem leitenden Material nach einem bevorzugten Verfahrensschritt durch eine Temperierung ("annealing") silizidiert. Hierdurch wird eine verbesserte Kontaktierung ermöglicht.

Ein ebenso bevorzugter Schritt des Verfahrens sieht vor, dass vor dem Auffüllen der Leiterbahnkanäle mit dem gut leitenden Material auf dem unter den Leiterbahnkanälen liegendem Halbleitermaterial und/oder den Seitenflächen der Seitenflächenisolation und/oder den Seitenflächen eine oder mehrere Schichten zur besseren Kontaktierung aufgebracht wird.

Ein ebenso vorteilhafter Aspekt der Erfindung betrifft ein Halbleiterbauelement mit einem Halbleiter-Substrat und mehreren gegenüber der Hauptoberfläche des Substrats aufragend ausgebildeten Elektrodenanschlüssen, wobei auf der Hauptoberfläche des Halbleiter-Substrats eine diese wenigstens teilweise bedeckende Isolationsschicht ausgebildet ist, welche Isolationsschicht wenigstens teilweise mit einer Isolationsdeckschicht bedeckt ist, und wenigstens einer der Elektrodenanschlüsse vollständig auf der Isolationsschicht bzw. der Isolationsdeckschicht ausgebildet ist und die weiteren Elektrodenanschlüsse wenigstens teilweise auf der Isolationsschicht bzw. der Isolationsdeckschicht ausgebildet sind.

Von Vorteil sind die Elektrodenanschlüsse aus dem selben Material und in gleichen vertikalen Dimensionen (Höhe über dem Substrat) ausgebildet. Hierdurch ist eine einheitliche Oberfläche gegeben und die Möglichkeit eröffnet sog. selbstjustierende Strukturierungen ("self aligned") zu verwenden.

Eine bevorzugte Ausgestaltung der Erfindung sieht vor, dass die Elektrodenanschlüsse aus ein und derselben Elektrodenanschluss-Schicht, insbesondere durch einen Ätz-Strukturierungs-Schritt, hergestellt sind. Hierdurch wird erreicht, dass die Elektrodenanschlüsse in ihren vertikalen Dimensionen und physikalischen Eigenschaften gleich sind.

Vorteilhafterweise liegt in dem Substrat unter wenigstens einem der Elektrodenanschlüsse ein hochdotierter Bereich. Durch einen solchen hochdotierten Bereich ist die Kontaktierung des Substrats und/oder eines Bereichs desselben möglich.

Eine vorteilhafte Ausgestaltung der Erfindung sieht vor, dass in dem Substrat unter wenigstens einem zwischen den Elektrodenanschlüsse liegenden Bereich ein dotierter Bereich liegt. Dem folgend ist nach einer weiteren sehr vorteilhaften und daher bevorzugten Ausgestaltung der Erfindung vorgesehen, dass das Halbleiterbauelement ein Feldeffekttransistor ist.

Auf einem ersten und/oder einem zweiten und/oder einem dritten Elektrodenanschluss ist von Vorteil ein gut leitendes Material aufgebracht. Hierdurch lassen sich metallische Kontakte und Leiterbahnen realisieren.

Daher sieht eine vorteilhafte Ausgestaltung der Erfindung vor, dass vermittels des gut leitenden Materials verschiedene auf dem gleichen Substrat ausgebildete Halbleiterbauelemente miteinander elektrisch verbunden sind.

Zur Verbesserung des Kontakts ist nach einer bevorzugten Ausgestaltung der Erfindung vorgesehen, dass das gut leitende Material mit dem darunter liegenden Material der Elektrodenanschlüsse durch eine Silizidierung verbunden ist.

Weitere Vorteile, Besonderheiten und zweckmäßige Weiterbildungen der Erfindung ergeben sich aus den weiteren Unteransprüchen.

Nachfolgend wird die Erfindung anhand der Zeichnung weiter erläutert. Im Einzelnen zeigen die schematischen Darstellungen in:
- Figur 1: eine schematische Querschnittsdarstellung durch ein Substrat mit flachen Grabenisolationen und darauf aufgebrachten Schichten;
- Figur 2: eine schematische Querschnittsdarstellung durch ein Substrat mit darauf aufgebrachten Schichten nach einem Strukturierungsschritt;
- Figur 3: eine schematische Querschnittsdarstellung durch ein Substrat mit darauf aufgebrachten Schichten und einer Elektrodenanschluss-Schicht;
- Figur 4: eine schematische Querschnittsdarstellung durch ein Substrat mit darauf aufgebrachten Elektrodenanschlüssen die aus den Schichten durch einen Strukturierungsschritt gefertigt wurden;
- Figur 5: eine schematische Querschnittsdarstellung durch ein Substrat mit darauf aufgebrachten Elektrodenanschlüssen mit Seitenisolierungsschichten;
- Figur 6: eine schematische Querschnittsdarstellung durch ein Substrat mit darauf aufgebrachten Elektrodenanschlüssen und hochdotierten Bereichen unterhalb der Elektrodenanschlüsse;
- Figur 7: eine schematische Querschnittsdarstellung durch ein Substrat mit darauf aufgebrachten, planarisierten Elektrodenanschlüssen und Auffüllungen zwischen den Elektrodenanschlüssen;
- Figur 8: eine schematische Querschnittsdarstellung durch ein Substrat mit darauf aufgebrachten Elektrodenanschlüssen und mit einer Leiterschicht ausgefüllten Vertiefungen;
- Figur 9: eine schematische Querschnittsdarstellung durch ein Substrat mit darauf aufgebrachten, planarisierten Elektrodenanschlüssen mit einer Leiterschicht;
- Figur 10: eine schematische Querschnittsdarstellung durch ein Substrat mit darauf aufgebrachten, planarisierten Elektrodenanschlüssen mit einer Leiterschicht und einem Substratanschluss; und
- Figur 11: eine schematische Querschnittsdarstellung durch ein Substrat mit darauf aufgebrachten, planarisierten Elektrodenanschlüssen mit einer Leiterschicht und einer Leiterbahn.

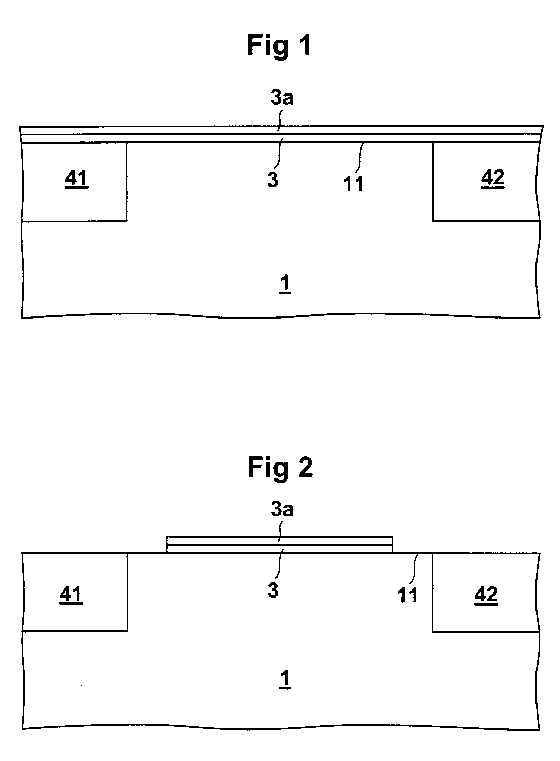

In den Figuren 1 bis 11 ist das erfindungsgemäße Verfahren zur Herstellung eines erfindungsgemäßen integrierten Halbleiterauelements bzw. eines Substratanschlusses und einer Leiterbahn dargestellt. Die Bezeichnung in den Figuren 1 bis 11 gelten hierbei für gleiche oder gleichwirkende Teile analog.

Figur 1 zeigt ein Halbleiter-Substrat 1 mit darin bereits hergestellten flachen Grabenisolationen ("shallow-trench isolations") 41 und 42 und mit einer auf diesen und auf der Hauptoberfläche 11 des Halbleiter-Substrats 1 ausgebildeten Isolationsschicht 3 und der auf der Isolationsschicht 3 ausgebildeten Isolationsdeckschicht 3a. Die Isolationsschicht 3 wird hierbei durch eine dünne (Gate-)Oxidschicht die Isolationsdeckschicht 3a durch eine dünne Polysilizium-Schicht gebildet. Die flachen Grabenisolationen sind nicht in jedem Fall erforderlich; sie werden anstelle des sonst hier üblichen Feldoxids verwendet.

In Figur 2 wurden die Isolationsschicht 3 und die Isolationsdeckschicht 3a durch einen ersten Lithografie- und Ätz-Schritt strukturiert, wodurch in kleinen Bereichen das Substrat 1 an der Oberfläche 11 zugänglich wird.

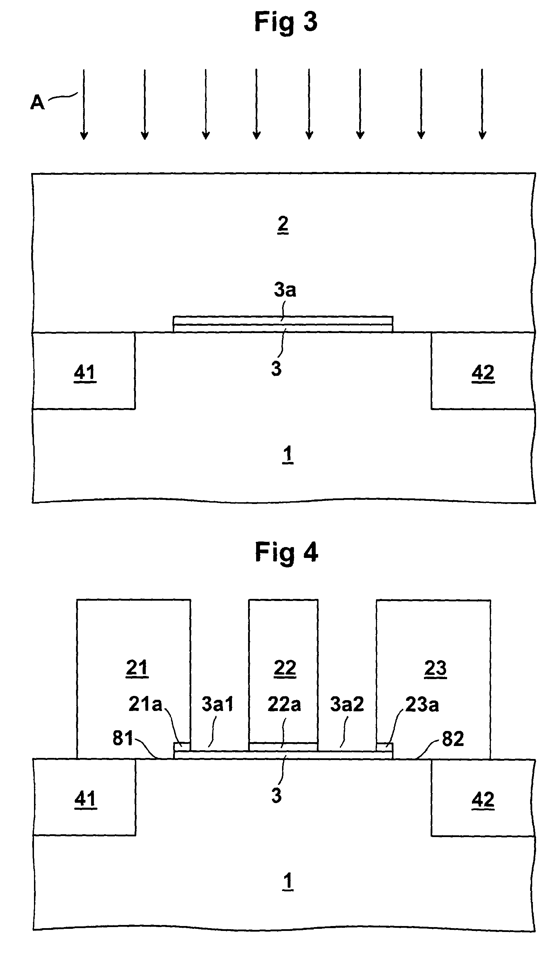

Da in den weiteren Prozess-Schritten aus der Elektrodenanschluss-Schicht 2 die Elektrodenanschlüsse gefertigt werden, muss die die Elektrodenanschluss-Schicht 2 bildende Polysilizium-Schicht bereits in Situ hoch dotiert sein oder nach deren Aufbringen in einem weiteren Schritt, wie in Figur 3 dargestellt, vermittels einer Diffusion A von geeignetem Dotierungsmaterial dotiert werden. Die Elektrodenanschluss-Schicht 2 wird hierbei auf der Oberfläche der Grabenisolationen 41 und 42 des Substrats 1 und der Isolationsdeckschicht 3a aufgewachsen beziehungsweise abgeschieden.

Anschließend hieran wird wie in Figur 4 dargestellt eine Strukturierung der Elektrodenanschluss-Schicht 2 und der Isolationsdeckschicht 3a vorgenommen, wodurch die Elektrodenanschlüsse 21, 22 und 23 entstehen. Der erste (Source-)Elektrodenanschluss 21 ist größtenteils auf der ersten flachen Grabenisolation 41 und zum kleineren Teil auf der zugänglichen Kontakt-Fläche 81 des Substrats 1 und auf der Isolationsdeckschicht 21a ausgebildet. Der zweite (Gate-)Elektrodenanschluss 22 ist elektrisch vom Substrat isoliert, da er vollständig auf der Isolationsschicht 3 beziehungsweise der Isolationsdeckschicht 22a ausgebildet ist. Der dritte (Drain-)-Elektrodenanschluss 23 ist wiederum größtenteils auf einer flachen Grabenisolation 42 und zum Teil auf einer das Substrat 1 freilegenden Kontakt-Fläche 82 und der Isolationsdeckschicht 23a ausgebildet. Die Source- und Drain-Elektrodenanschlüsse 21 und 23 stehen also nur zum Teil mit dem Substrat auf den Teilflächen 81 und 82 in elektrischem Kontakt. Dadurch, dass die Dimensionen der Elektrodenanschlüsse größer sind als die Kontaktstellen 81 und 82 mit dem Substrat, sind die Kontaktwiderstände geringer.

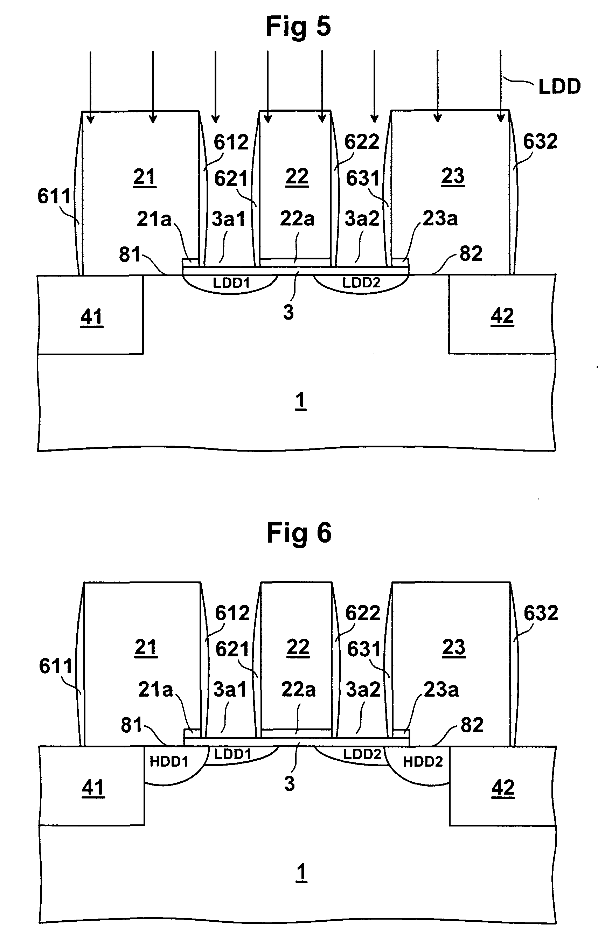

In Figur 5 sind die nächsten Prozess-Schritte dargestellt. Zunächst werden durch eine Reoxidation an den Seitenflächen der Elektrodenanschlüsse 21, 22 und 23 Seitenisolationsschichten 611 bis 632 hergestellt. Hierdurch werden die Elektrodenanschlüsse vor den nächsten Prozessschritten geschützt und insbesondere eine ungewollte Dotierung verhindert. Die Herstellung der für einen Feldeffekt-Transistor notwendigen dotierten Bereiche LDD1 und LDD2 im Halbleiter-Substrat 1 erfolgt vermittels geeigneter Dotierstoffe LDD durch Implantation und durch einen geeigneten Temperierungsprozess ("annealing"). Die Dotierstoffe LDD werden in das Halbleiter-Substrat 1 hinein diffundiert (durch die Isolationsschicht 3 hindurch), wodurch die dargestellten dotierten Bereiche LDD1 und LDD2 direkt unter den freiliegenden Bereichen 3a1 und 3a2 der Isolationsschicht 3 entstehen.

In Figur 6 ist die bereits aus den Elektrodenanschlüssen 21 und 23 in das Substrat hinein erfolgte Diffusion von hochdotierten Dotierstoffen vollzogen, wodurch die dargestellten hochdotierten (Kontakt-)bereiche HDD1 und HDD2 im Substrat 1 entstehen. Die hochdotierten (Kontakt-)bereiche HDD1 und HDD2 dienen hierbei zur Erreichung eines verbesserten elektrischen Übergangs bzw. einer Kontaktierung der dotierten Bereiche LDD1 und LDD2.

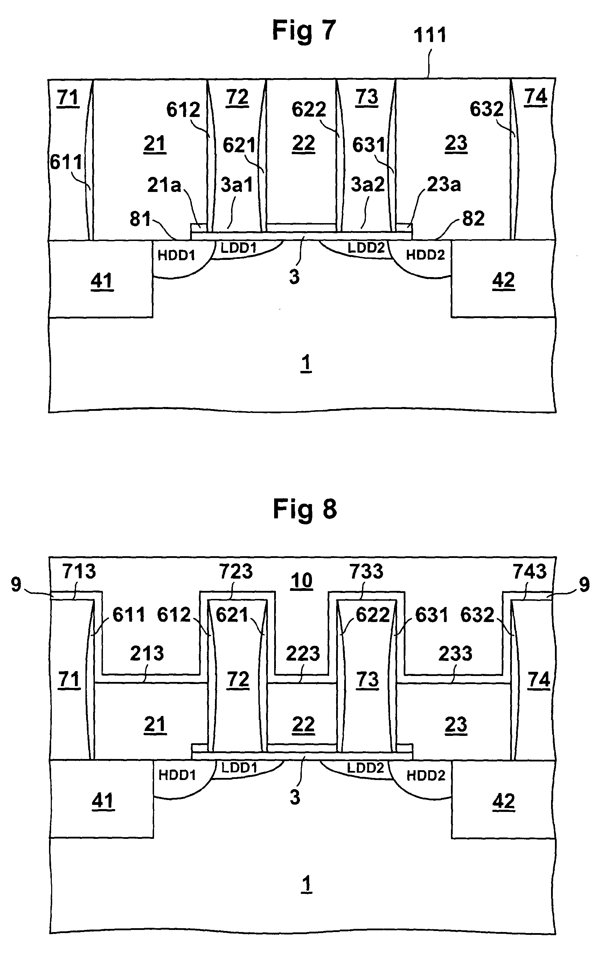

Zur Planarisierung der Oberfläche 111 werden die restlichen Unebenheiten und Vertiefungen zwischen den Elektrodenanschlüssen mit Auffüllungen 41 bis 74 aufgefüllt (Figur 7). Hierzu kann beispielsweise Bor-Phosphor-Silikatglas Verwendung finden. Die Oberfläche kann hierbei vermittels eines chemisch-mechanischen Polierprozesses zusätzlich geglättet werden. Da in diesem Stadium die auf und in dem Halbleiter-Substrat 1 aufgebrachte Struktur völlig planarisiert ist, kann ein standardmäßiger Silizidationsprozess zur Herstellung der Kontakte beziehungsweise der Leiterbahnen ohne weiteres durchgeführt werden. Das hierzu notwendige Metall könnte einfach abgeschieden werden und in einem geeigneten Temperierungsprozess ("annealing") die Silizidation auf den Elektrodenanschlüssen 21, 22 und 23 hervorrufen. Das übrig gebliebene, nicht mit dem Halbleitermaterial reagierte Metall könnte danach in einem geeigneten Ätzprozess leicht entfernt werden.

Ein weiterer Ansatz zur Herstellung der Kontakte beziehungsweise der Leiterbahnen ist in Figur 8 dargestellt. Hierbei wurden bereits zunächst vermittels eines geeigneten Ätzprozesses, beispielsweise eines reaktiven Ionen-Ätzprozesses die aus Polysilizium bestehenden Elektrodenanschlüsse 21 bis 23 bis zu einer vorbestimmten Höhe abgetragen. Für den reaktiven Ionen-Ätzprozess kann hierbei eine Ätzgas-Mischung auf Brombasis Verwendung finden, da so eine gute Selektivität des Ätzprozesses bezüglich der Elektrodenanschlüsse erfolgt.

Nach geeigneter Säuberung der Oberflächen, beispielsweise durch eine Wasserstoff-Fluor-Verbindung, wird eine dünne Kontaktschicht 9, beispielsweise aus einer Titan-Nitridschicht abgeschieden und - wie in Figur 8 dargestellt - mit einer Leiterschicht 10 überzogen, die die Vertiefungen in der Oberfläche wieder füllt. Die Leiterschicht 10 kann hierbei geeigneterweise aus Wolfram bestehen und füllt die durch die Abtragung der Elektrodenanschlüsse 21 bis 23 entstandenen Vertiefungen und Leiterbahnkanäle. Denkbar sind hier auch Wolframnitridverbindungen oder Schichten aus Titan, Titannitrid und Wolfram oder anstelle Wolfram Aluminium oder Kupfer in Verbindung mit Tantal anstelle von Titan.

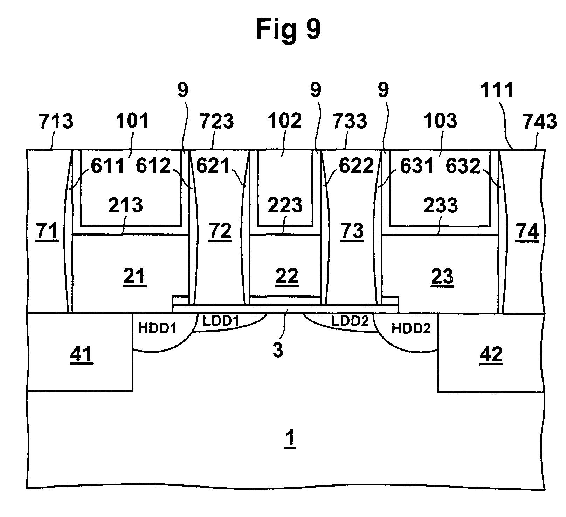

Figur 9 zeigt das Ergebnis eines weiteren Planarisierungsprozesses, bevorzugterweise wiederum eines chemisch-mechanischen Polierprozesses, wodurch die Oberfläche 111 der Struktur geglättet wird. Die aufgebrachte Metallschicht (10, 101 bis 103) wird hierzu bis auf Höhe der vom Substrat abgewandten Oberflächen 713 bis 743 der Auffüllungen 71 bis 74 abgetragen. Somit entsteht eine sehr gut leitende Leiterbahnschicht aus Metall in der Struktur, wobei die Oberfläche 111 einheitlich und eben ist.

Für den chemisch-mechanischen Polierprozess wird vorzugsweise eine Wasserstoffperoxyd-Lösung verwendet, da diese vorteilhafterweise keine unerwünschten Verunreinigungen (Elemente) enthält, die beispielsweise in den sonst standardmäßig verwendeten Eisennitratlösungen vorkommen. Deren Eisenbestandteile diffundieren in Form von Eisenionen unerwünschterweise in das kristalline Silizium (Substrat, Anschlüsse) ein und wirken dort als störende Rekombinationszentren. Nach dem Polierprozess ist die Struktur zur Durchführung weiterer Prozesse an den Kontakten bereit, welche durch hochauflösende Lithografie vorgenommen werden kann, da keine Unebenheiten die Fokussierung behindern.

Die nach dem Verfahren der Erfindung schließlich gewonnene völlig planarisierte Oberfläche der Struktur kann wiederum leicht zur Ausbildung von weiteren Schichten verwendet werden. Anders als bisher üblich sind so in einfacher Weise Multi-Layer-Strukturen herstellbar beziehungsweise erstmals möglich.

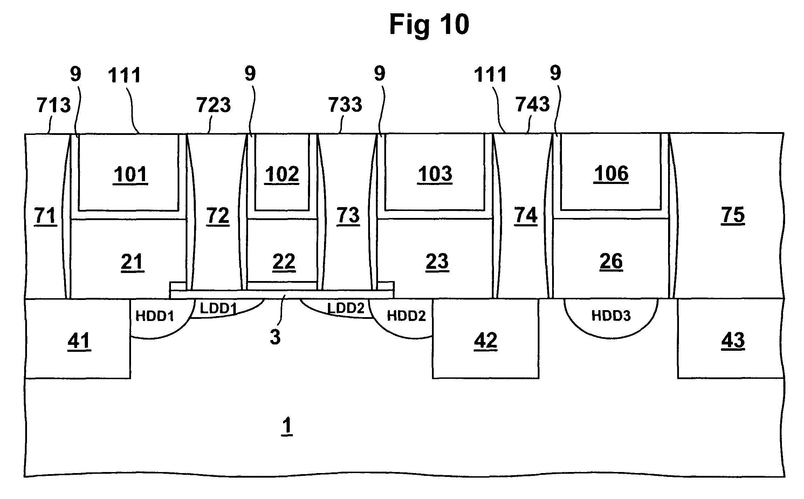

In Figur 10 ist nochmals ein Querschnitt durch eine auf einem Halbleitersubstrat 1 auf- und eingebrachte Struktur gezeigt, wobei zusätzlich ein Substratanschluss gezeigt ist, der simultan mit den Elektrodenanschlüssen 21, 22 und 23 hergestellt wird, und zur Verbesserung der Substratkontaktierung einen hochdotierten Bereich HDD3 unter seinem Elektrodenanschluss 26 und darauf befindlichen Leiterschicht 106 aufweist. Der hochdotierte Bereich HDD3 wird wiederum durch eine Diffusion von Dotierungsmaterial aus der Elektrode 26 hergestellt.

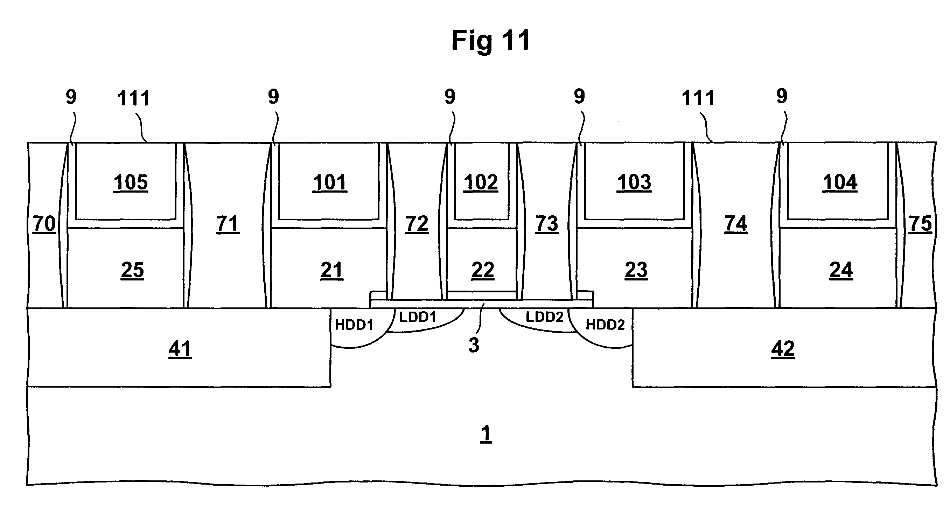

Schließlich zeigt Figur 11 einen ebenso beispielhaft gewählten Querschnitt durch eine durch das erfindungsgemäße Verfahren hergestellte Struktur, wobei einzelne Bauelemente verbindende Leiterbahnen 104 und 105 beziehungsweise 24 und 25, die ebenfalls auf flachen Grabenisolationen 41 und 42 ausgebildet sind, dargestellt sind.

## Patentansprüche

1. Verfahren zur Herstellung eines auf einem Halbleiter-Substrat (1) ausgebildeten integrierten Bauelements mit mehreren gegenüber der Hauptoberfläche (11) des Substrats aufragend ausgebildeten Elektrodenanschlüssen (21, 22, 23, 26), mit den Verfahrensschritten:
- Ausbilden einer das Substrat wenigstens teilweise bedekkenden Isolationsschicht (3) auf der Hauptoberfläche (11) des Halbleiter-Substrats (1),
- Ausbilden einer Isolationsdeckschicht (3a) auf der Isolationsschicht (3),
- Teilweises entfernen der Isolationsschicht (3) mit der darüber liegenden Isolationsdeckschicht (3a),
- Aufbringen einer Elektrodenanschluss-Schicht (2) auf der Hauptoberfläche (11) des Halbleiter-Substrats (1) und/oder auf der Isolationsdeckschicht (3a), und
- Gleichzeitiges Ausbilden der erhöhten, gegenüber der Hauptoberfläche (11) aufragenden Elektrodenanschlüsse (21, 22, 23, 26) durch Entfernen der Elektrodenanschluss-Schicht (2), insbesondere durch einen Ätzvorgang, in an die zu schaffenden Elektrodenanschlüsse (21, 22, 23, 26) angrenzenden Bereichen und/oder durch Entfernen der Isolationsdeckschicht (3a) in an den zu schaffenden Elektrodenanschluss angrenzenden Bereichen (3a1, 3a2).

2. Verfahren nach Anspruch 1,
**dadurch gekennzeichnet,**
**dass** gleichzeitig mit den Elektrodenanschlüssen (21, 22, 23, 26) das Halbleiterbauelement mit weiteren auf bzw. in dem Halbleiter-Substrat (1) ausgebildeten, integrierten Bauelementen verbindende Leiterbahnen (24, 25) hergestellt werden.

3. Verfahren nach Anspruch 2,
**dadurch gekennzeichnet,**
**dass** die Leiterbahnen (24, 25) aus der Elektrodenanschluss-Schicht (2) hergestellt werden, wobei die Elektrodenanschluss-Schicht (2) in an die zu schaffenden Leiterbahnen (24, 25) angrenzenden Bereichen, insbesondere durch einen Ätzvorgang, entfernt wird.

4. Verfahren nach einem der Ansprüche 1 bis 3,
**dadurch gekennzeichnet,**
**dass** ein erster und/oder ein dritter Elektrodenanschluss (21, 23) direkt auf dem Substrat (1) und/oder zum Teil auf der Isolationsdeckschicht (3a, 21a, 23a) ausgebildet wird.

5. Verfahren nach einem der Ansprüche 1 bis 4,
**dadurch gekennzeichnet,**
**dass** ein zweiter Elektrodenanschluss (22) vollständig auf der Isolationsdeckschicht (22a) ausgebildet wird.

6. Verfahren nach einem der Ansprüche 1 bis 5,
**dadurch gekennzeichnet,**
**dass** nach der Herstellung der Elektrodenanschlüsse (21, 22, 23, 26) auf dem Halbleiter-Substrat (1) bzw. auf der Isolationsdeckschicht (3a, 21a, 22a, 23a) wenigstens ein innerhalb des Halbleiter-Substrats (1) liegender dotierter Bereich (LDD1, LDD2) ausgebildet wird.

7. Verfahren nach Anspruch 6,
**dadurch gekennzeichnet,**
**dass** der dotierte Bereich (LDD1, LDD2) unterhalb der Isolationsschicht (3) und teilweise unter wenigstens einem Elektrodenanschluss (21, 22, 23, 26) ausgebildet wird.

8. Verfahren nach Anspruch 6 oder 7,
**dadurch gekennzeichnet,**
**dass** der dotierte Bereich (LDD1) durch eine Diffusion eines Dotierungs-Materials (LDD) durch die Isolationsschicht (3) und/oder aus dieser in das Halbleiter-Substrat (1) hinein hergestellt wird.

9. Verfahren nach einem der Ansprüche 1 bis 8,
**dadurch gekennzeichnet,**
**dass** wenigstens ein erster und ein zweiter Elektrodenanschluss (21 und 22) wenigstens teilweise auf der Isolationsschicht (3) hergestellt werden, wobei in einem Zwischen-Bereich (3a1) zwischen den beiden Elektrodenanschlüssen (21 und 22) die Elektrodenanschluss-Schicht (2) und die Isolationsdeckschicht (3a) über der Isolationsschicht (3) entfernt werden.

10. Verfahren nach Anspruch 9,
**dadurch gekennzeichnet,**
**dass** der dotierter Bereich (LDD1) in dem Zwischen-Bereich (3a1) unter der Isolationsschicht (3) hergestellt wird.

11. Verfahren nach einem der Ansprüche 7 bis 10,
**dadurch gekennzeichnet,**
**dass** vor dem Herstellen des dotierten Bereichs (LDD1) Seitenisolierungsschichten (611 bis 632) an den Seitenflächen des wenigstens einen Elektrodenanschlusses (21, 22, 23) hergestellt werden, sodass die Eindiffusion des Dotierungs-Materials (LDD) in den wenigstens einen Elektrodenanschluss (21, 22, 23) vermieden wird.

12. Verfahren nach einem der Ansprüche 1 bis 11,
**dadurch gekennzeichnet,**
**dass** wenigstens drei Elektrodenanschlüsse (21, 22 und 23) hergestellt werden und dass zwischen jeweils zwei der drei Elektrodenanschlüsse (21, 22 und 23) je ein dotierter Bereich (LDD1 und LDD2) unter der Isolationsschicht (3) im Halbleiter-Substrat (1) hergestellt werden.

13. Verfahren nach einem der Ansprüche 1 bis 12,
**dadurch gekennzeichnet,**
**dass** in den Bereichen (81, 82, 83) in denen die Elektrodenanschlüsse (21, 23, 26) direkt auf dem Substrat ausgebildet sind Dotierstoffe von den Elektrodenanschlüssen (21, 23, 26) in Eindiffusionsbereiche (HDD1, HDD2, HDD3) des Substrats (1) zur besseren Kontaktierung der Elektrodenanschlüsse (21, 23, 26) mit dem Substrat und/oder des dotierten Bereichs (LDD1, LDD2) hinein diffundiert werden, insbesondere durch einen Temperierungsprozess ("annealing").

14. Verfahren nach einem der Ansprüche 1 bis 13,
**dadurch gekennzeichnet,**
**dass** die Elektrodenanschluss-Schicht (2) und/oder wenigstens einer der Elektrodenanschlüsse (21, 23) und/oder wenigstens eine Leiterbahn (24, 25) teilweise oder ganz über wenigstens einer in dem Halbleiter-Substrat (1) ausgebildeten flachen Grabenisolation (41, 42, 43) ("shallow-trench isolation") ausgebildet wird.

15. Verfahren nach Anspruch 1 bis 14,
**dadurch gekennzeichnet,**
**dass** ein Feldeffekttransistor mit wenigstens einem Source-(21) einem Gate- (22) und einem Drain-Anschluss (23) und/oder ein Substratanschluss (26) hergestellt wird.

16. Verfahren nach einem der Ansprüche 1 bis 15,
**dadurch gekennzeichnet,**
**dass** auf dem Substrat (1) und/oder der Isolationsschicht (3) und zwischen den Elektrodenanschlüssen (21 bis 23, 26) und/oder den Leiterbahnen (24, 25) eine Auffüllung (70 bis 75) dergestalt aufgebracht wird, dass eine planarisierte, ebene Oberfläche (111) entsteht, die mit der dem Substrat abgewandten Seite (112) der Elektrodenanschlüsse (21 bis 23, 26) und/oder der Leiterbahnen (24, 25) abschließt.

17. Verfahren nach einem der Ansprüche 1 bis 16,
**dadurch gekennzeichnet,**
**dass** wenigstens einer der Elektrodenanschlüsse (21, 22, 23, 26) und/oder der Leiterbahnen (24, 25) bis zu einer vorbestimmten Höhe abgetragen werden.

18. Verfahren nach Anspruch 17,
**dadurch gekennzeichnet,**
**dass** die sich durch das Abtragen des/der Elektrodenanschlusses (21, 22, 23, 26) bzw. der Leiterbahn(en) (24, 25) zwischen den vormals diesen angrenzenden Auffüllungen (70 bis 75) gebildete Vertiefung mit einer Leiterschicht (101 bis 106) aus einem gut leitenden Material (10) ausgefüllt wird.

19. Verfahren nach einem der Ansprüche 18,
**dadurch gekennzeichnet,**
**dass** nach dem Auffüllen der Vertiefung mit dem gut leitenden Material (10) durch eine Temperierung ("annealing") eine Silizidierung des gut leitenden Materials (10) mit dem darunter liegendem Elektrodenanschluss (21, 22, 23, 26) oder der Leiterbahn (24, 25) bzw. der Elektrodenanschluss-Schicht (2) hergestellt wird.

20. Verfahren nach Anspruch 18 oder 19,
**dadurch gekennzeichnet,**
**dass** vor dem Auffüllen mit dem gut leitenden Material (102 bis 106) die die Vertiefung bildende von der Hauptoberfläche (11) des Substrats (1) abgewandte Seitenfläche (213, 223, 233) des Elektrodenanschlusses (21, 22, 23, 26) oder der Leiterbahn (24, 25) und/oder die der Vertiefung zugewandten Seitenflächen der Auffüllung (70 bis 75) oder der Seitenflächenisolationsschichten (611 bis 632) mit einer Kontaktschicht (9) bedeckt werden.

21. Verfahren nach einem der Ansprüche 18 bis 20,
**dadurch gekennzeichnet,**
**dass** die Auffüllung mit dem gut leitenden Material eine Leiterschicht ("local interconnect system") bildet, mit der einzelne integrierte auf bzw. in dem Halbleiter-Substrat (1) ausgebildete Bauelemente miteinander verbunden werden.

22. Verfahren nach einem der Ansprüche 1 bis 21,
**dadurch gekennzeichnet,**
**dass** die Oberfläche (111) des auf dem Substrat (1) ausgebildeten integrierten Bauelements bzw. Bauelementen und der Auffüllungen (70 bis 75) vermittels eines chemisch-mechanischen Polierprozesses poliert wird.

23. Verfahren nach Anspruch 22,
**dadurch gekennzeichnet,**
**dass** für den chemisch-mechanischen Polierprozesses ein Wasserstoffperoxyd enthaltendendes Schleif/Poliermittel verwendet wird.

24. Verfahren nach einem der Ansprüche 16 bis 23,
**dadurch gekennzeichnet,**
**dass** für die Auffüllungen (70 bis 74) Oxid und/oder Bor-Phosphor-Silikatglas verwendet wird.

25. Verfahren nach einem der Ansprüche 18 bis 24,
**dadurch gekennzeichnet,**
**dass** als gut leitendes Material (10) Titan und/oder Wolfram und/oder Aluminium und/oder Tantal und/oder Kupfer und/oder Gold und/oder Platin und/oder eine Kombination derselben verwendet wird.

26. Verfahren zur Herstellung von elektrischen Verbindungen (24, 25, 101 bis 106) zwischen einzelnen auf bzw. in einem Halbleiter-Substrat (1) ausgebildeten Schaltungselementen (21, 22, 23, 26, LDD1, LDD2, HDD1 bis HDD3),
**gekennzeichnet durch** die Verfahrensschritte:
- Herstellen der einzelnen, zu verbindenden Schaltungselementen in (LDD1, LDD2, HDD1 bis HDD3) bzw. auf (21, 22, 23, 26) dem Halbleitersubstrat (1),
- Planarisieren der Schaltungselemente auf bzw. in dem Halbelitersubstrat (1) durch Auffüllen von Vertiefungen und Unebenheiten mit einem Füllmaterial (70 bis 75),
- Fertigen von Leiterbahnkanälen in die planarisierte Fläche (111, 112) aus Schaltungselementen (LDD1, LDD2, HDD1 bis HDD3, 21, 22, 23, 26) und Füllmaterial (70 bis 75) hinein, und
- Auffüllen der Leiterbahnkanäle mit einem gut leitenden Material (10, 101 bis 106).

27. Verfahren nach Anspruch 26,
**dadurch gekennzeichnet,**
**dass** nach dem Auffüllen der Leiterbahnkanäle mit dem gut leitenden Material (10, 101 bis 106) das unter den Leiterbahnkanälen liegende Halbleitermaterial (2, 21 bis 26) mit dem leitenden Material (10, 101 bis 106) durch eine Temperierung ("annealing") silizidiert wird.

28. Verfahren nach Anspruch 26 oder 27,
**dadurch gekennzeichnet,**
**dass** vor dem Auffüllen der Leiterbahnkanäle mit dem gut leitenden Material (10, 101 bis 106) auf dem unter den Leiterbahnkanälen liegendem Halbleitermaterial (2, 21 bis 26) und/oder den Seitenflächen der Seitenflächenisolation (611 bis 632) und/oder den Seitenflächen (211 bis 232) eine oder mehrere Schichten (9) zur besseren Kontaktierung aufgebracht wird.

29. Verfahren nach Anspruch 28,
**dadurch gekennzeichnet,**
**dass** die Schicht(en) (9) zur Verbesserung der Kontaktierung aus einer Kontaktschicht und/oder einer Barrierenschicht zur Verhinderung von Metalldiffusion in das Halbleitermaterial (2) bestehen.

30. Verfahren nach einem der vorherigen Ansprüche,
**dadurch gekennzeichnet,**
**dass** als gut leitendes Material (10, 101 bis 106) Titan uns/oder Wolfram und/oder Aluminium und/oder Tantal und/oder Kupfer und/oder Gold und/oder Platin verwendet wird.

31. Halbleiterbauelement mit einem Halbleiter-Substrat (1) und mehreren gegenüber der Hauptoberfläche (11) des Substrats aufragend ausgebildeten Elektrodenanschlüssen (21, 22, 23),
**dadurch gekennzeichnet,**
**dass** auf der Hauptoberfläche (11) des Halbleiter-Substrats (1) eine diese wenigstens teilweise bedeckende Isolationsschicht (3) ausgebildet ist, wobei die Isolationsschicht (3) wenigstens teilweise mit einer Isolationsdeckschicht (3a, 21a, 22a, 23a) bedeckt ist, und wenigstens einer der Elektrodenanschlüsse (22) vollständig auf der Isolationsschicht bzw. der Isolationsdeckschicht ausgebildet ist und die weiteren Elektrodenanschlüsse (21, 23) wenigstens teilweise auf der Isolationsschicht bzw. der Isolationsdeckschicht ausgebildet sind.

32. Halbleiterbauelement nach Anspruch 31,
**dadurch gekennzeichnet,**
**dass** die Elektrodenanschlüsse (21, 22, 23) aus dem selben Material (2) und in gleichen vertikalen Dimensionen (Höhe über dem Substrat) ausgebildet sind.

33. Halbleiterbauelement nach Anspruch 31 oder 32,
**dadurch gekennzeichnet,**
**dass** die Elektrodenanschlüsse (21, 22, 23) aus ein und derselben Elektrodenanschluss-Schicht (2), insbesondere durch einen Ätz-Strukturierungs-Schritt, hergestellt sind.

34. Halbleiterbauelement nach einem der Ansprüche 31 bis 33,
**dadurch gekennzeichnet,**
**dass** in dem Substrat (1) unter wenigstens einem der Elektrodenanschlüsse (21 und 23) ein hochdotierter Bereich (HDD1 und HDD2) liegt.

35. Halbleiterbauelement nach einem der Ansprüche 31 bis 34,
**dadurch gekennzeichnet,**
**dass** in dem Substrat (1) unter wenigstens einem zwischen den Elektrodenanschlüsse (21 und 22, 22 und 23) liegenden Bereich (3a1, 3a2) ein dotierter Bereich (LDD1 und LDD2) liegt.

36. Halbleiterbauelement nach einem der Ansprüche 31 bis 35,
**dadurch gekennzeichnet,**
**dass** das Halbleiterbauelement ein Feldeffekttransistor ist.

37. Halbleiterbauelement nach einem der Ansprüche 31 bis 36,
**dadurch gekennzeichnet,**
**dass** auf einem ersten (21) und/oder einem zweiten (22) und/oder einem dritten (23) Elektrodenanschluss ein gut leitendes Material (10, 101, 102, 103) aufgebracht ist.

38. Halbleiterbauelement nach Anspruch 37,
**dadurch gekennzeichnet,**
**dass** vermittels des gut leitenden Materials (10, 101, 102, 103) verschiedene auf dem gleichen Substrat (1) ausgebildete Halbleiterbauelemente miteinander elektrisch verbunden sind.

39. Halbleiterbauelement nach einem der Ansprüche 37 oder 38,
**dadurch gekennzeichnet,**
**dass** gut leitendes Material (10, 101, 102, 103) wenigstens teilweise aus Titan und/oder aus Wolfram und/oder aus Aluminium und/oder aus Tantal und/oder aus Kupfer und/oder Platin und/oder Gold besteht.

40. Halbleiterbauelement nach einem der Ansprüche 37 bis 39,
**dadurch gekennzeichnet,**
**dass** das gut leitende Material (10, 101, 102, 103) mit dem darunter liegenden Material der Elektrodenanschlüsse (2, 21, 22, 23) durch eine Silizidierung verbunden ist.
